# EUROPEAN PATENT APPLICATION

(11) **EP 1 280 203 A2**
(43) Date of publication of application: **29.01.2003**
(21) Application number: 02255214.5
(22) Date of filing: 26.07.2002
(51) Int. Cl.: H01L 23/48, H01L 25/065, H01L 23/04

(54) **3D-Semiconductor Package**

(30) Priority: 27.07.2001 JP 2001228566
(71) Applicant: Nokia Corporation, 02150 Espoo (FI)
(72) Inventor: Amit, Dutta, Kawasaki-shi, Kanagawa-ken (JP); Iwamoto, Takashi, Urayasu-shi, Chiba-ken (JP); Fujii, Takaharu, Yokohama-shi, Kanagawa-ken (JP); Yoshimura, Makoto, Tagata-gun, Shizuoka-ken (JP)
(74) Representative: Higgin, Paul

(57) **Abstract**

A semiconductor package is provided which enables various interconnections between pins at a low cost. In an embodiment of the invention, the semiconductor package has a base substrate and a group of IC's (spacer IC's, routing IC's, and flip chip IC's) stacked on the base substrate in three dimensions. The routing IC is an interposer for wiring between the pins of the chips located above and below the routing IC and enables the integration of passive elements.

## Description

The present invention relates to a semiconductor package and, more particularly, to a semiconductor package wherein semiconductor IC's are stacked in three dimensions (hereinafter referred to as a "3D-package").

In recent years, a technology for producing various machinery or tools with a larger density and larger integration scale has been advancing and the "System on Chip" for performing the integration of a plurality of function blocks into a single chip has been improved and developed. However, the "System on Chip" has involved problems that the larger scale "System on Chip" leads to a higher development cost and designing in a brief period of time is of an extremely high difficulty level.

Therefore, a design concept, "System in Package" where a plurality of chips are integrated into one package to form a single system, has captured the spotlight instead of the "System on Chip." Representative examples of the "System in Package" include a MCM (Multi Chip Module) and a 3D-package.

The MCM comprises a plurality of chips integrated into a single wiring board and allows reduction in production cost and time involved in designing compared with the "System on Chip." However, the MCM involves problems that the area and thickness of a wiring board increase and the production cost becomes expensive as the system is scaled up.

As for the 3D-package, for example, U.S. Patent No. 5,973,396 has been proposed, wherein a space-saving semiconductor package with a reduced occupied area is provided by stacking IC chips in three dimensions. However, U.S. Patent No. 5,973,396 requires that all the IC's to be stacked are specifically designed, so that it can provide no solution for the same problems as the "System on Chip" design approach, such as a higher development cost and a longer design period.

In consideration of the foregoing problems involved in the related art, an object of the invention is to provide a semiconductor package which enables interconnections between various pins at a low cost.

Another object of the invention is to provide a semiconductor package which permits increases in density and speed.

To solve the foregoing problems, the invention features a semiconductor package comprising all or any of the following: routing IC's, flip chip IC's, and spacers, stacked in three dimensions where the routing IC includes a plurality of through holes for connecting with its adjacent layers or the base substrate and electric means for interconnecting the top and bottom surfaces of the routing IC.

It is preferred that the semiconductor package comprises routing IC's having one or more passive elements.

It is preferred that the semiconductor package comprises routing IC's having one or more active elements.

It is preferred that the semiconductor package comprises a plurality of routing IC's which differ from each other in the numbers of the through holes, the active elements, and/or the passive elements provided or in the area occupied thereby.

It is preferred that the semiconductor package comprises an electric means for changing the routing of the routing IC's.

It is preferred that the semiconductor package comprises an electric means for changing the construction of passive elements and/or active elements, which are placed on the routing of the routing IC.

It is preferred that bonding between the individual layers of the semiconductor package is performed by solder balls or a conductive adhesive.

The invention disclosed herein will be understood better with reference to the accompanying drawings, in which:
Fig. 1 is a schematic illustration showing the entire arrangement of a semiconductor package in an embodiment of the invention;
Fig. 2 is a cross sectional view of a semiconductor package in a first embodiment of the invention;
Fig. 3 is a cross sectional view of a semiconductor package in a second embodiment of the invention;
Fig. 4 is a cross sectional view of a routing IC in an embodiment of the invention;
Fig. 5 is a cross sectional view of a flip chip IC used in the invention; and
Fig. 6 is a cross sectional view of a custom IC used in the invention.

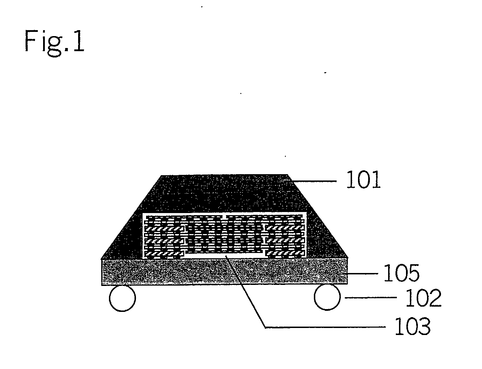

With reference to Figs. 1 to 6, the embodiments of the invention will be described below.

While the routing IC is an interposer with a function for wiring pins of chips located above and below the routing IC, it is also an IC that enables the integration of passive elements including a resistor R, an inductor L, and a capacitor C. The passive elements are intended to provide impedance matching, decoupling, and the like which must be considered in connecting chips.

While this "routing IC" may incorporate active elements, it may have a function for allowing a change in routing after the production of IC's using the well-known techniques in this case. With such routing IC, a semiconductor package according to the invention may have a function of reconstituting an internal circuit.

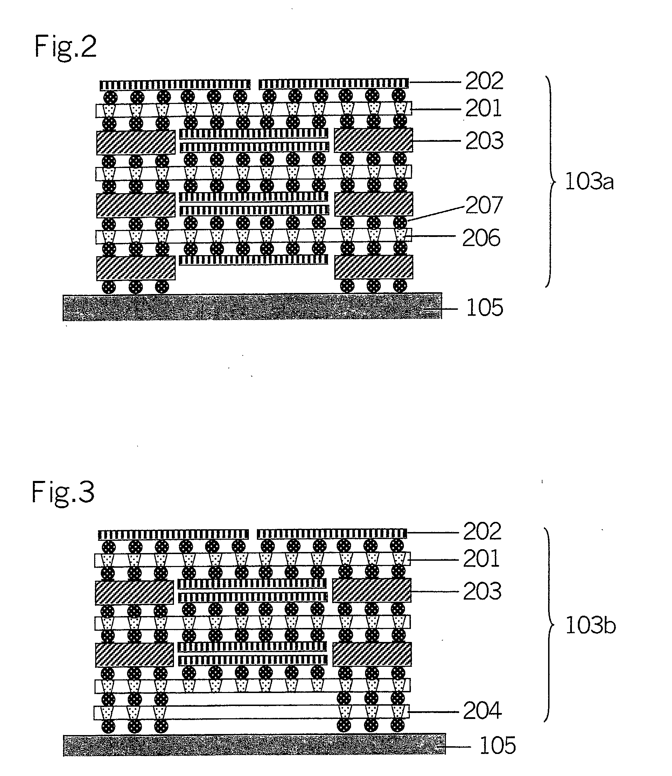

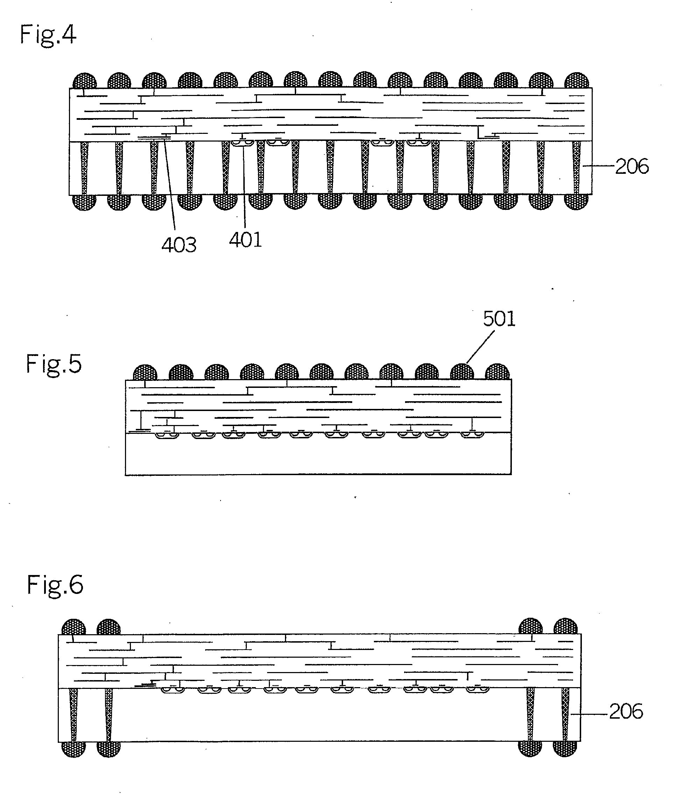

Turning now to the drawings, Fig. 1 shows the entire arrangement of a semiconductor package in an embodiment of the invention; Fig. 2 shows a first embodiment of the invention; Fig. 3 shows a second embodiment of the invention; Fig. 4 shows a cross section of a routing IC in an embodiment of the invention; Fig. 5 shows a cross section of a flip chip IC used in the invention; and Fig. 6 shows a cross section of a custom IC used in the invention.

Referring to Fig. 1, a semiconductor package in an embodiment of the invention comprises a group of IC's 103 stacked in three dimensions; a base substrate 105 on which the group of IC's 103 is mounted; an encapsulant 101 for encapsulating the resultant substrate with the group of IC's; and external connections 102 on a rear surface of base substrate 105 opposite from the group of IC's 103.

Referring now to Fig. 2, there are illustrated cross sections of a group of IC's 103a assembled by through hole silicon stacking of the first embodiment, and a base substrate 105. As shown in Fig. 2, the group of IC's (spacer IC's 203, routing IC's 201, and flip chip IC's 202) 103a is stacked in three dimensions on the base substrate 105.

As described above, the routing IC 201 is an IC for wiring between pins of chips located above and below the routing IC and has through holes 206, each for connecting this routing circuit to layers stacked above and below the routing circuit (adjacent layers or the base substrate). The routing IC 201 can incorporate at least one of the following (1) to (4) according to the application in which it is used.
(1) Passive elements
(2) Active elements
(3) A circuit for changing the routing
(4) A circuit for changing the construction of passive elements and/or active elements which are placed on the routing.

To bond the routing IC 201 with IC's located above the routing IC (or below the routing IC), it is possible to use either of the following well known means:
(1) solder balls; and
(2) conductive adhesives including ACFs (Anisotropic Conductive Films).

The layers 201 to 203 each perform reception and transmission of input/output signals through I/O pins 207. For bonding between layers, solder balls or conductive adhesives (e.g. ACF) may be used.

The routing IC 201 can be fabricated utilizing the same techniques as silicon substrate IC's here. However, unlike the CPU fabrication, the routing IC does not need the most advanced and costly design rule and apparatuses, so that it can be fabricated at a lower cost.

In this embodiment, it is also possible to integrate an active element, such as a transistor, into the routing IC 201 to make the I/O paths programmable. In this case, connection paths between pins provided on the sides of routing IC 201 can be switched. Consequently, for example, even when the specifications of the adjacent layer (e.g. a flip chip IC 202) are changed or when there are any mistake (or any change) in the system design, the routing can be readily changed with just programming. Of course, it is possible to additionally incorporate a logic circuit in the routing IC 201 and to allow the logic circuit to be reconstituted as well as to change the routing.

The substrate material of the routing IC 201 may be any of silicon, glass, ceramic (alumina), or polymers. However, the type of passive element integrated may be restricted depending on selected substrate material.

The flip chip IC 202 may be a well-known standard flip chip IC and the semiconductor material thereof may be Si, GaAs, or the like. While this IC 202 isn't changed usually, it can be subject to minor change in bonding pads due to improvement (or modification) in the bonding techniques.

The spacer IC 203 may be routing IC 201 with a different thickness or may comprise a flexible substrate. It is conceivable to use solder balls or conductive adhesives (e.g. ACF) for bonding the spacer IC 203 with chips located above and below the spacer IC. Further, it is possible to use polymers as the substrate material.

Fig. 3 illustrates a cross section of a group of IC's 103b to which the through hole silicon stacking in the second embodiment is applied, and a base substrate 105. In Fig. 3, like parts are identified by the same reference character as shown in Fig. 2 to omit the descriptions therefor. As shown in Fig. 3, a custom IC 204 is stacked on a base substrate 105. In this manner, a custom IC 204 can be incorporated to achieve a 3D-package according to the invention. Now, the custom IC 204 is a specifically designed IC, wherein through holes 206 are formed therethrough.

Examples capable of incorporating a semiconductor package according to the invention are:
(1) RF integrated circuits, wherein a compound semiconductor is used.
(2) Logic circuits (e.g. CPUs and DSPs)
(3) Memories (e.g. DRAMs, SRAMs, and flash memories)
(4) Sensors

Fig. 4 shows a cross section of a routing IC 201 used in the invention. The through holes 206 are filled with conductor and serve to electrically connect layers adjacent vertically with each other, or an adjacent layer with a base substrate 105. In the routing IC 201, many passive elements (e.g. resistors R, inductors L, and capacitors C403) and a small number of active elements (e.g. transistors 401 and diodes) are integrated.

Fig. 5 shows a cross section of a flip chip IC 202 used in the invention, wherein the solder ball bonding is adapted to bonding of the flip chip. In the flip chip IC, its I/O pins protrude directly from a surface of the IC and the chip bumps 501 are composed of solder solely.

Fig. 6 shows a cross section of a custom IC 204 used in the invention. The custom IC 204 is a specifically designed IC through which holes 206 are formed. When a new function not available in commercial IC's is required, it is possible to incorporate in the package a custom IC 204 wherein the required function and routing circuits and through holes are formed.

While the embodiments of the invention have been described above, the advantages of the invention will now be listed.
1. It has been impossible to incorporate existing IC's directly in a 3D-package which has been proposed heretofore. However, according to the invention, existing flip chip IC's can be incorporated in a 3D-package as they are, so that the design period and manufacturing cost can be reduced significantly.
2. It is also possible to incorporate a specifically designed IC, wherein through holes are formed therethrough, if required. In addition, this IC can be reused for a 3D-package in a modification of the invention.
3. The routing IC 201 is an IC which is primarily intended to perform the routing as its name indicates, so that there is no need for using the most advanced integration technology unlike the CPU fabrication. Consequently, the manufacturing cost of the packages can be kept lower, because it is often possible to accomplish good performances even when they are produced by a lower cost production method.
4. The routing IC can incorporate a switching circuit, thereby providing a 3D-package with the ability to reconstruct an internal circuit.
5. It becomes possible to cut down on costs of and to expedite 3D-package designing.
6. It especially becomes possible to cut down on costs of a packaging technology where compound semiconductor IC's are used, and a packaging technology for DSPs.
7. Integrating passive elements into a routing IC, the passive elements can be integrated into the package of the invention. As a result, the number of passive components which have been required to be mounted on a separate board can be reduced.
8. Therefore, it is possible to achieve space-savings and speedups for semiconductor packages without sacrificing the design periods and manufacturing costs.

Therefore, according to the invention, it is possible to provide a semiconductor package which enables space-saving and operation speedup while reducing the design time and manufacturing cost.

## Claims

1. A semiconductor package comprising:
all or any of the group consisting of: routing IC's, flip chip IC's, and spacers; and a base substrate,
wherein all or any of said IC's and spacers are stacked in three dimensions on the base substrate of the semiconductor package, and said routing IC comprises:
through holes for connecting with the routing IC's adjacent layers or the base substrate; and
electric means for wiring respectively the top and bottom surfaces of said routing IC.

2. The semiconductor package according to claim 1, wherein said routing IC comprises one or more passive elements.

3. The semiconductor package according to either claim 1 or 2, wherein said routing IC comprises one or more active elements.

4. The semiconductor package according to any of claims 1 to 3, wherein said routing IC's differ from each other in the numbers of said through holes, said active elements, and/or said passive elements provided and in the area these occupy.

5. The semiconductor package according to any of claims 1 to 4 further comprising an electric means for changing the routing of said routing IC's.

6. The semiconductor package according to any of claims 1 to 5 further comprising an electric means for changing the construction of passive elements and/or active elements, which are placed on the routing of said routing IC.

7. The semiconductor package according to any of claims 1 to 6 wherein bonding between the individual layers is performed by solder balls or a conductive adhesive.
